Europäisches Patentamt

European Patent Office

Office européen des brevets

(19)

(11) Numéro de publication: **0 262 017 B1**

(12) **FASCICULE DE BREVET EUROPEEN**

(45) Date de publication de fascicule du brevet: **29.04.92**

(51) Int. Cl.5: **H02M 1/08**, H03K 17/04

(21) Numéro de dépôt: **87401961.5**

(22) Date de dépôt: **02.09.87**

(54) **Dispositif de commande des bases des transistors d'un bras d'onduleur.**

(30) Priorité: **15.09.86 FR 8612962**
**15.09.86 FR 8612963**

(43) Date de publication de la demande:
**30.03.88 Bulletin 88/13**

(45) Mention de la délivrance du brevet:
**29.04.92 Bulletin 92/18**

(84) Etats contractants désignés:
**BE CH DE ES GB IT LI NL SE**

(56) Documents cités:
EP-A- 0 108 662
EP-A- 0 167 431
FR-A- 2 441 290

PATENT ABSTRACTS OF JAPAN, vol. 7, no.
247 (E-208)[1392], 2 novembre 1983; & JP-
A-58 133 184 (MATSUSHITA DENKO K.K.)
08-08-1983

CONTROL ENGINEERING, vol. 28, no. 8, août
1981, pages 129-136, St. Pontiac, Illinois, US;
J.F. SHOUP et al.: " High voltage thyristors
used in precipitator"

(73) Titulaire: **MERLIN GERIN**
**Rue Henri Tarze**
**F-38050 Grenoble Cédex(FR)**

(72) Inventeur: **Cuman, Sylvain**
**Merlin Gerin Service Brevets**
**F-38050 Grenoble Cédex(FR)**
Inventeur: **Moreau, Philippe**
**Merlin Gerin Service Brevets**
**F-38050 Grenoble Cédex(FR)**

(74) Mandataire: **Kern, Paul**
**Merlin Gerin Sce. Brevets 20, rue Henri Tarze**
**F-38050 Grenoble Cédex(FR)**

Rank Xerox (UK) Business Services
(−/2.18/2.0)

## Description

L'invention est relative à un dispositif de commande de deux transistors bipolaires de puissance montés en série entre des conducteurs d'une source de tension continue de service et ayant un point milieu de sortie pour former un bras d'onduleur, chaque transistor ayant un bloc de commande de base alimenté par une source de tension continue de commande de valeur prédéterminée (FR-A-2.441.290).

A chaque phase de l'onduleur correspond un bras ayant deux transistors en série soumis à la tension de service qui atteint généralement plusieurs centaines de volts. A chaque transistor est associée une commande de base capable de fournir un courant de base de plusieurs ampères sous une faible tension, notamment de quelques volts, pour une mise en conduction du transistor ainsi qu'une faible tension négative de blocage du transistor. Ces tensions de commande sont généralement dérivées des tensions élevées de service, ce qui pose des problèmes d'isolation dans le cas du bras d'onduleur à deux transistors connectés en série.

Le document EP-A-167.431 décrit un circuit de commande d'un transistor de puissance à travers un transformateur d' isolement galvanique.

L'article "Hight Voltage Thyristors used in Precipitator", paru en août 1981 dans la revue "CONTROL ENGINEERING", vol. 28, décrit un circuit de commande d'une série de thyristors de puissance destinés à être commandés simultanément. Ce circuit comporte plusieurs transformateurs dont les primaires, connectés en série, reçoivent un signal de commande et dont les enroulements secondaires transmettent à la fois le signal de commande et l'énergie nécessaire à la partie du circuit de commande et l'énergie nécessaire à la partie du circuit de commande associée à l'un des thyristors.

La présente invention a pour but de permettre la réalisation d'une commande des transistors d'un bras d'onduleur simplifiée et capable de tenir les tensions élevées de service.

Le dispositif selon l'invention est caractérisé en ce que les deux blocs de commande sont séparés galvaniquement et connectés à un même bloc d'alimentation ayant un transformateur comportant un enroulement primaire commun relié à ladite tension de service par l'intermédiaire d'un commutateur et deux enroulements secondaires distincts, chaque enroulement secondaire alimentant l'un des blocs de commande par l'intermédiaire de redresseurs, le bloc d'alimentation comportant un régulateur de tension comprenant un enroulement tertiaire dudit transformateur et un dispositif piloté par l'enroulement tertiaire et commandant ledit commutateur.

Chaque transistor dispose de son propre bloc de commande porté au potentiel du transistor et les deux blocs de commande sont alimentés par le même bloc d'alimentation, qui respecte l'isolation galvanique des deux blocs de commande, grâce à un transformateur d'alimentation à deux enroulement secondaires indépendants, chacun associé à l'un des blocs de commande. Cette séparation galvanique assure la tenue à la différence de tension de plusieurs centaines de volts, à laquelle sont soumis les deux blocs de commande des deux transistors. Le transformateur d'alimentation comporte un enroulement primaire commun aux deux enroulements secondaires et la régulation en tension est assurée par un régulateur comportant un commutateur statique inséré dans le circuit primaire du transformateur. Ce commutateur statique est piloté par un enroulement tertiaire du transformateur par l'intermédiaire d'un dispositif provoquant l'ouverture périodique du commutateur statique pour réguler la tension de sortie. Chaque enroulement secondaire comporte une prise médiane et aux bornes d'extrémités de cet enroulement secondaire sont connectés des redresseurs à diode pour fournir les tensions de commande positives et négatives, respectivement de conduction et de blocage du transistor.

Un autre but de l'invention consiste à assurer la protection du transistor contre les surtensions et ce but est atteint en connectant aux bornes du transistor, entre le collecteur et l'émetteur, un condensateur en série avec une diode. Toute surtension apparaissant aux bornes du transistor est dérivée dans le circuit de shuntage à diode et à condensateur, ce dernier absorbant la surtension en se chargeant. La décharge du condensateur est réalisée à travers un circuit résistif reliant le condensateur à la source de tension de service de polarité opposée.

Dans un mode de réalisation préférentiel chaque bloc de commande comporte des moyens pour connecter sélectivement la base du transistor associé à travers une résistance à une source de tension positive de commande pour la mise en conduction du transistor et pour connecter la base du transistor à une source de tension négative de commande, pour le blocage du transistor, lesdits moyens de connexion de la base du transistor à la source de tension positive comprenant, connectés en série, un régulateur de courant délivrant un courant constant et une inductance d'accumulation d'énergie pour augmenter la vitesse de croissance du courant de base du transistor lors d'une commande de conduction et compenser la self parasite d'émetteur.

Le régulateur de courant définit avec précision la valeur du courant de base assurant la conduction du transistor, tandis que l'inductance compense ou annule l'effet parasite de la self d'émetteur, cette inductance constituant une réserve d'énergie disponible lors de la mise en conduction du transistor. Le régulateur de courant comprend avantageusement un capteur de courant qui pilote un amplificateur de régulation commandant un commutateur statique inséré dans le circuit de commande de base. Le blocage du transistor est réalisé par la fermeture d'un commutateur statique qui dérive le courant délivré par le régulateur de courant vers la source de tension en établissant simultanément un courant de base négatif à travers une résistance vers la source de tension négative. Cette source de tension négative polarise la base du transistor pour maintenir ce dernier bloqué.

D'autres avantages et caractéristiques ressortiront plus clairement de la description qui va suivre, d'un mode de mise en oeuvre de l'invention donné à titre d'exemple non limitatif et représenté aux dessins annexés dans lesquels :

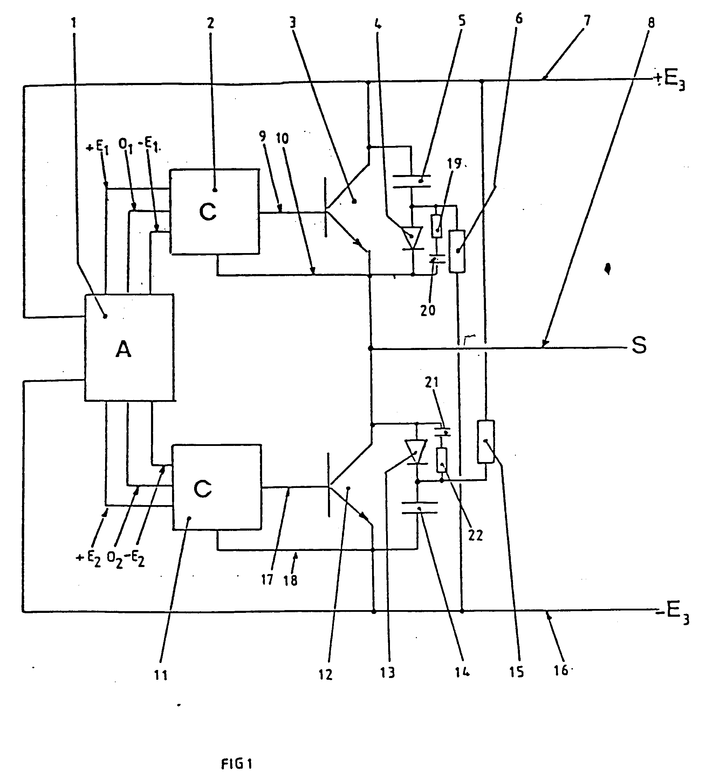

- La figure 1 représente le schéma électrique d'un bras d'onduleur à deux transistors avec leur circuit de commande ;
- La figure 2 représente le schéma électrique du bloc d'alimentation des circuits de commande selon la figure 1 ;
- Les figures 3 et 4 représentent le schéma électrique d'un bloc de commande d'un transistor respectivement en position de conduction et de blocage ;
- La figure 5 montre la variation du courant de base de commande d'un transistor selon la figure 1 ;
- La figure 6 illustre la variation de la tension base émetteur du transistor.

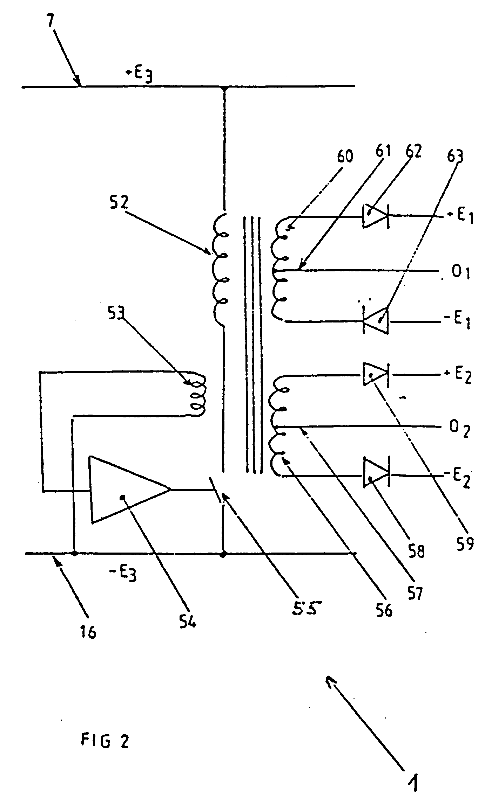

Une tension électrique continue élevée +E3, -E3 est appliquée à des conducteurs 7, 16 par une source de tension (non représentée), par exemple un accumulateur ou un redresseur. Un bras d'onduleur constitué par deux transistors de puissance 3, 12 connectés électriquement en série est relié aux conducteurs 7, 16 et un conducteur de sortie 8 est relié au point de connection des deux transistors 3, 12. Lorsque le transistor 3 relié à la tension +E3 est conducteur, la sortie S est portée au potentiel +E3 tandis que lors de la conduction du transistor 12, cette sortie est portée au potentiel -E3 d'une manière bien connue des spécialistes. Chaque transistor 3, 12 est relié à un bloc de commande 2, 11, d'une part par un conducteur 9, 17 connectant la base du transistor au bloc de commande 2, 11 et d'autre part par un conducteur 10, 18 reliant l'émetteur du transistor 3, 12 au bloc de commande 2, 11. Les blocs de commande 2, 11, qui seront décrits en détail par la suite, pilotent la conduction et le blocage alternatif des transistors 3, 12 pour engendrer une tension alternative sur le conducteur 8 de sortie. La tension continue +E3, -E3, qui peut atteindre plusieurs centaines de volts, est égalèment appliquée à un bloc d'alimentation 1 fournissant aux blocs de commande 2, 11, une tension d'alimentation de quelques volts. En se référant plus particulièrement à la figure 2, on voit que le bloc d'alimentation 1 comporte un transformateur dont l'enroulement primaire 52 est relié aux conducteurs 7, 16, un commutateur statique 55 étant inséré dans le circuit primaire. Le commutateur statique 55 appartient à un régulateur de tension de type connu, représenté de façon très schématique sur la figure et comportant un enroulement tertiaire 53 du transformateur qui pilote un dispositif 54 de commande du commutateur statique 55. Le transformateur comporte deux enroulements secondaires distincts 56, 60, ayant chacun une prise médiane 57, 61 fournissant la tension de sortie 0 de commande O1, O2. Les extrémités des enroulements secondaires 56, 60 fournissent par l'intermédiaire de redresseurs à diode 58, 59 ; 62, 63 les tensions de sortie +E1, -E1 ; +E2, -E2. Ces tensions de commande délivrées par le transformateur sont de quelques volts, en l'occurrence une fraction de la tension de service +E3, -E3. Les tensions de commande +E1, O1, -E1 délivrées par l'enroulement secondaire 60 alimentent le bloc de commande 2 du transistor 3 tandis que les tensions +E2 ,O2, -E2 délivrées par l'enroulement secondaire 56 alimentent le bloc de commande 11 du transistor 12. La séparation des enroulement secondaires 56, 60 assure une isolation entre les blocs de commande 2, 11 qui peuvent être à des potentiels élevés différents.

Aux bornes du transistor 3 est connecté un circuit de shuntage constitué par un condensateur 5 et une diode 4, connectés électriquement en série, le condensateur 5 étant d'une part relié au collecteur du transistor 3, et d'autre part à l'anode de la diode 4 dont la cathode est reliée à l'émetteur du transistor 3. Le point de connexion du condensateur 5 et de l'anode de la diode 4 est d'autre part relié par une résistance 6 au conducteur 16 de tension -E3. Aux bornes de la diode 4 est connecté un circuit constitué par une résistance 19 et un condensateur 20. D'une manière analogue, le transistor 12 est shunté par un circuit constitué par une diode 13 et un condensateur 14, l'anode de la diode 13 étant reliée au collecteur du transistor 12 tandis que le condensateur 14 est relié à l'émetteur du transistor 12. Le point de connexion entre la diode 13 et le condensateur 14 est relié par une résistance 15 au conducteur 7 de tension +E3. La diode 13 est shuntée par un circuit comprenant une résistance 22 et un condensateur 21. Le circuit de shuntage à condensateur 5, 14 et diode 4, 13 en série protège le transistor 3, 12 contre les surtensions, la résistance 6, 15 maintenant le condensateur 5, 14 chargé.

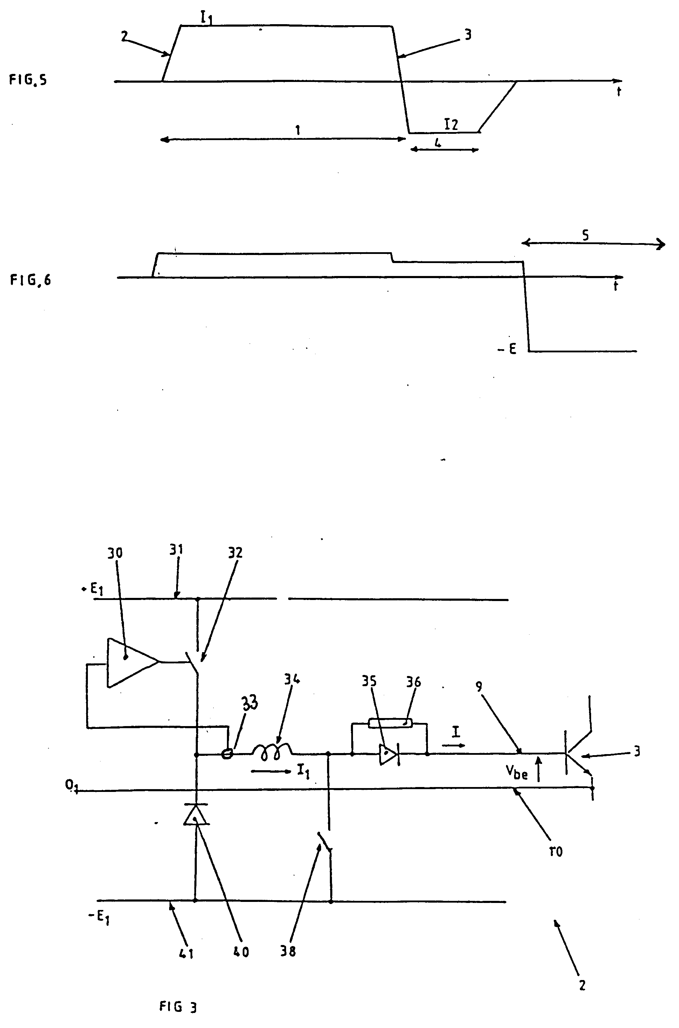

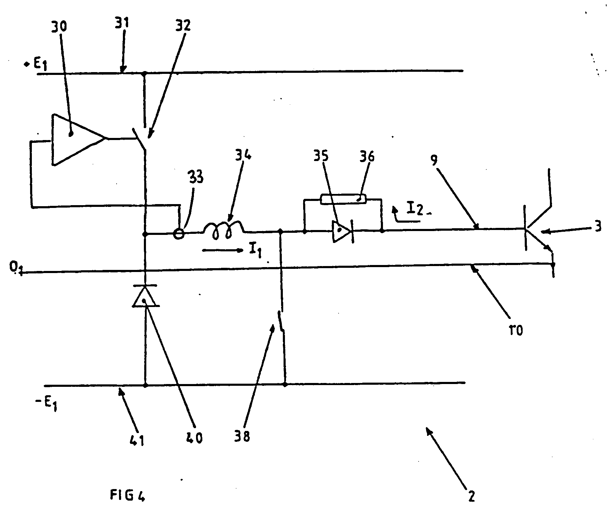

Seul le bloc de commande 2 associé au transistor 3 est décrit ci-dessous en référence à la figure 3, le bloc de commande 11 du transistor 12 étant absolument identique. La base du transistor 3 est reliée au conducteur 31 à la tension +E1 par un circuit 9 constitué par un commutateur statique 32, une inductance 34 et une diode 35 connectés électriquement en série. La diode 35 est shuntée par une résistance 36. Le commutateur statique 32 appartient à un régulateur de courant comprenant un capteur 33, qui pilote un amplificateur de régulation 30 qui commande le commutateur statique 32. Lorsque les tensions +E1 et -E1 sont appliquées aux conducteurs 31 et 41, lors de la mise en route du circuit, le commutateur statique 32 est normalement fermé et le courant traversant le capteur 33 augmente jusqu'à un premier seuil, dit seuil haut. Dès que ce seuil est atteint l'amplificateur de régulation 30 commande l'ouverture du commutateur statique et le courant traversant le capteur diminue jusqà atteindre un second seuil, dit seuil bas, commandant de nouveau la fermeture du commutateur statique. Le courant de sortie du régulateur de courant varie donc entre les deux valeurs de seuil précitées de manière à ce que sa valeur moyenne soit maintenue constante. Ce régulateur de courant 30, 32, 33 délivre donc un courant constant I1 pour la commande de conduction du transistor 3. L'émetteur du transistor 3 est relié à la tension 0, O1 et le point de connexion de l'inductance 34 et de l'anode de la diode 35 est relié par un commutateur statique 38 au conducteur 41 à la tension de commande - E1. L'anode d'une diode de retour 40 est connectée au conducteur 41 à la tension -E1, la cathode de cette diode étant reliée au point de liaison du commutateur 32 et de l'inductance 34.

En position ouverte du commutateur 38, représentée à la figure 3, le courant I1, maintenu à une valeur constante par le régulateur de courant 30, 32, 33, se referme par l'inductance 34, la diode 35 et la base du transistor 3 dans l'alimentation O1. Le transistor 3 est conducteur, la dio de 40 assurant le retour du courant pendant les phases de blocage du commutateur 32. En position fermée du commutateur 38, représentée à la figure 4, le courant I1 est dérivé par ce commutateur 38 vers le conducteur 41, tandis qu'un courant continu de base négatif I2 s'établit à travers la résistance 36 et le commutateur 38 vers le conducteur 41. Ce courant continu négatif provoque le blocage du transistor 3. La base du transisor 3 est polarisée à travers la résistance 36 à la tension -E1 maintenant le blocage du transistor 3.

Il est utile de rappeler que la commande de base d'un transistor impose les conditions suivantes :

1) délivrer un courant continu positif de commande d'une valeur précise I1 pendant le temps de conduction du transistor ;

2) réaliser un temps de montée rapide du courant de base au moment de la mise en conduction du transistor ;

3) réaliser un temps de descente rapide du courant de base au moment du blocage du transistor ;

4) délivrer un courant continu négatif I2 de valeur précise pendant le temps de blocage de la base du transistor ;

5) appliquer une tension continue négative -E1 pendant le temps de blocage du transistor.

Le circuit émetteur du transistor 3 présente une self parasite qui tend à s'opposer à l'établissement du courant de base IB de mise en conduction du transistor 3. Selon la présente invention, cette self parasite est compensée par l'inductance 34 qui constitue un réservoir d'énergie imposant une croissance rapide du courant de base IB lors de l'ouverture du commutateur 38, malgré la présence de la self d'émetteur parasite. La valeur du courant I1 est déterminée avec précision par le régulateur du courant 30, 32, 33. Il est utile de noter que le courant de commande I1 qui peut atteindre plusieurs ampères ne traverse aucune résistance et que la puissance dissipée dans le circuit de commande est particulièrement faible et une fraction de celle des circuits de commande standards. Les commutateurs 38 des circuits de commande 2, 11 sont pilotés par des dispositifs standards pour rendre conducteur alternativement les transistors 3, 12 et engendrer un courant alternatif de fréquence prédéterminée. Il est inutile de décrire ces circuits de commande des commutateurs 38 qui peuvent être d'un type quelconque.

Les figures 5 et 6 illustrent respectivement la variation du courant de base IB et de la tension base émetteur du transistor 3 qui confirme le respect des conditions pré-citées.

## Revendications

1. Dispositif de commande de deux transistors (3, 12) bipolaires de puissance montés en série entre des conducteurs (7, 16) d'une source de tension continue (+E3, -E3) de service et ayant un point milieu (8) de sortie pour former un bras d'onduleur, chaque transistor (3, 12) ayant un bloc (2, 11) de commande de base alimenté par une source de tension continue de commande (+E1, O1, -E1 ; +E2, O2, -E2) de valeur prédéterminée, caractérisé en ce que les deux blocs de commande (2, 11) sont séparés galvaniquement et connectés à un même bloc d'alimentation (1) ayant un transformateur comportant un enroulement primaire (52) commun relié à ladite tension de service (+E3, -E3) par l'intermédiaire d'un commutateur (55) et deux enroulements secondaires (56, 60) distincts, chaque enroulement secondaire (56, 60) alimentant l'un des blocs de commande (2, 11) par l'intermédiaire de redresseurs (58, 59, 62, 63), le bloc d'alimentation comportant un régulateur de tension (53, 54, 55) comprenant un enroulement tertiaire (53) dudit transformateur et un dispositif (54) piloté par l'enroulement tertiaire et commandant ledit commutateur (55).

2. Dispositif selon la revendication 1, caractérisé en ce que chaque enroulement secondaire (56, 60) comporte un point milieu (57, 61) pour délivrer une tension de commande positive (+E1, +E2) et une tension de commande négative (-E1, -E2) par rapport à la tension nulle (01, 02) du point milieu (57, 61).

3. Dispositif selon la revendication 2, caractérisé en ce que chaque bloc de commande (2, 11) comprend un commutateur (38) pour appliquer sélectivement un courant de base de conduction du transistor (3, 12) ou annuler le courant de base pour bloquer le transistor.

4. Dispositif selon l'une quelconque des revendications précédentes, caractérisé en ce qu'un condensateur (5, 14) en série d'une diode (4, 13) est connecté entre le collecteur et l'émetteur du transistor (2,11) pour limiter les surtensions et qu'un circuit de décharge à résistance (6, 15) relie le point de connexion entre le condensateur et la diode au potentiel opposé de la tension de service (+E3, -E3).

5. Dispositif selon la revendication 4, caractérisé en ce qu'aux bornes desdites diodes (4, 13) est connecté un circuit de shuntage ayant en série une résistance (19, 22) et un condensateur (20, 21).

6. Dispositif selon l'une quelconque des revendications 1 à 5, caractérisé en ce que chaque bloc de commande (2,11) comporte des moyens pour connecter sélectivement la base du transistor associé à travers une résistance (36) à une source (31) de tension positive (+E1, +E2) de commande pour la mise en conduction du transistor et pour connecter la base du transistor à une source (41) de tension négative (-E1, -E2) de commande, pour le blocage du transistor, lesdits moyens de connexion (9,17) de la base du transistor à la source (31) de tension positive (+E1, +E2) comprenant, connectés en série, un régulateur de courant (30,32,33) délivrant un courant constant, et une inductance (34) d'accumulation d'énergie pour augmenter la vitesse de croissance du courant de base du transistor lors d'une commande de conduction et compenser la self parasite d'émetteur.

7. Dispositif selon la revendication 6, caractérisé en ce que dans ledit circuit de connexion (9,17), ladite résistance (36) est insérée entre l'inductance (34) et la base du transistor, en étant shuntée par une diode (35), le point de connexion entre l'inductance et la résistance étant relié par l'intermédiaire d'un commutateur statique (38) de commande à ladite source (41) de tension négative (-E1, -E2) de commande.

8. Dispositif selon l'une des revendications 6 et 7, caractérisé en ce que ledit régulateur de courant (30,32,33) comporte un capteur (33) de courant parcourant ladite inductance (34), un amplificateur de régulation (30) piloté par ledit capteur (33) et un commutateur (32) commandé par ledit amplificateur pour maintenir constante la valeur moyenne hachée du courant.

9. Dispositif selon l'une quelconque des revendications 6 à 8, caractérisé en ce que le point de connexion entre l'inductance (34) et le régulateur (30,32,33) est relié par une diode (40) à la source (41) de tension négative de commande (-E1, -E2) pour permettre le retour du courant.

## Claims

1. A control device of two bipolar power transistors (3, 12) mounted in series between two conductors (7, 16) of a direct voltage operating supply (+E3, -E3) and having a center output point (8) to form an inverter arm, each transistor (3, 12) having a base control unit (2, 11) supplied by a direct control voltage supply (+E1, O1, -E1; +E2, O2, -E2) of predetermined value, characterized in that the two control units (2, 11) are galvanically separated and connected to a same supply unit (1) having a transformer comprising primary common winding (52) connected to said operating voltage (+E3, -E3) by means of a switch (55) and two distinct secondary windings (56, 60), each secondary winding (56, 60) supplying one of the control units (2, 11) by means of rectifiers (58, 59, 62, 63), the supply unit comprising a voltage regulator (53, 54, 55) including a tertiary winding (53) of said transformer and a device (54) controlled by the tertiary winding and controlling said switch (55).

2. The device according to claim 1, characterized in that each secondary winding (56, 60) comprises a center point (57, 61) for delivering a positive control voltage (+E1, +E2) and a negative control voltage (-E1, -E2) with respect to a zero voltage (01, 02) of the center point (57, 61).

3. The device according to claim 2, characterized in that each control unit (2, 11) comprises a switch (38) to selectively apply a base conduction current to the transistor (3, 12) or to cancel the base current to block the transistor.

4. The device according to any one of the preceding claims, characterized in that a capacitor (5, 14) in series with a diode (4, 13) is connected between the collector and the emitter of the transistor (2, 11) to limit overvoltages and in that a discharge circuit with a resistor (6, 15) connects the connecting point between the capacitor and the diode to the opposite potential from the operating voltage (+E3, -E3).

5. The device according to claim 4, characterized in that a shunt circuit having in series a resistor (19, 22) and a capacitor (20, 21) is connected to the terminals of said diodes (4, 13).

6. The device according to any one of claims 1 to 5, characterized in that each control unit (2, 11) comprises means of selectively connecting the associated transistor base via a resistor (36) to a supply (31) of positive control voltage (+E1, +E2) to make the transistor conducting and for connecting the transistor base to a supply (41) of negative control voltage (-E1, -E2) to block the transistor, said connecting means (9, 17) of the transistor base to the supply (31) of positive voltage (+E1, +E2) comprising, connected in series, a current regulator (30, 32, 33) delivering a constant current and an energy storage inductor (34) to increase the rise speed of the transistor base current on a conduction order and to counteract the emitter interference inductance.

7. The device according to claim 6, characterized in that in said connecting circuit (9, 17) said resistor (36) is inserted between the inductor (34) and the transistor base, being shunted by a diode (35), the connecting point between the inductor and the resistor being connected by means of a static control switch (38) to said supply (41) of negative control voltage (-E1, -E2).

8. The device according to claim 6 and 7, characterized in that said current regulator (30, 32, 33) comprises a sensor (33) of the current flowing through said inductor (34), a regulating amplifier (30) controlled by said sensor (33) and a switch (32) controlled by said amplifier to keep the mean chopped current value constant.

9. The device according to any one of the claims 6 to 8, characterized in that the connecting point between the inductor (34) and the regulator (30, 32, 33) is connected by a diode (40) to the supply (41) of negative control voltage (-El, -E2) to enable current feedback.

**Patentansprüche**

1. Treiberschaltung fur zwei bipolare, zwischen den Versorgungsleitungen (7, 16) einer Betriebs-Gleichspannungsquelle (+E3, -E3) in Reihe geschaltete Leistungstransistoren (3, 12) mit einem Ausgangs-Bezugspotential (8) zur Bildung eines Wechselrichterzweigs, wobei jeder Transistor (3, 12) mit einer Basis-Ansteuerlogik (2, 11) betrieben wird, die über eine Steuer-Gleichspannungsquelle (+E1, 01, -E1; +E2, 02, -E2) mit einem vorgegebenen Wert gespeist wird, dadurch gekennzeichnet, daß die beiden Ansteuerlogikschaltungen (2, 11) galvanisch voneinander getrennt sind und aus einer gemeinsamen Spannungsquelle (1) gespeist werden, die aus einem Transformator mit einer gemeinsamen, über einen Umschaltkontakt (55) mit der genannten Betriebsspannung (+E3, -E3) verbundenen Primärwicklung (52) sowie zwei getrennten Sekundärwicklungen (56, 60) besteht, die über Brückengleichrichter (58, 59, 62, 63) je eine Ansteuerlogik (2, 11) speisen, wobei die Spannungsquelle mit einem Spannungsregler (53, 54, 55), bestehend aus einer Tertiärwicklung (53) des genannten Transformators, ,und einer über die Tertiärwicklung angesteuerten schaltlogik (54), die den genannten Umschaltkontakt (55) steuert, ausgerüstet ist.

2. Schaltungsanordnung nach Anspruch 1, dadurch gekennzeichnet, daß jede Sekundärwicklung (56, 60) einen Mittelabgriff (57, 61) mit Nullpotential (01, 02) zur Bereitstellung einer darauf bezogenen positiven Steuerspannung (+E1, +E2) und einer negativen Steuerspannung (-E1, -E2) aufweist.

3. Schaltungsanordnung nach Anspruch 2, dadurch gekennzeichnet, daß sich in jeder Ansteuerlogik (2, 11) ein Umschaltkontakt (38) befindet, um den Transistor (3, 12) wahlweise über den zugeführten Basisstrom durchzuschalten oder durch Ableitung des Basisstroms zu sperren.

4. Schaltungsanordnung nach einem der genannten Ansprüche, dadurch gekennzeichnet, daß zur Vermeidung von Überspannungen zwischen Kollektor und Emitter des Transistors (2, 11) ein Kondensator (5, 14) und eine Diode (4, 13) in Reihe geschaltet sind, und daß ein Entladestromkreis mit einem Widerstand (6, 15) den Anschlußpunkt zwischen Kondensator und Diode mit dem entgegengesetzten Potential der Betriebs-Gleichspannung (+E3, -E3) verbindet.

5. Schaltungsanordnung nach Anspruch 4, dadurch gekennzeichnet, daß parallel zur genannten Diode (4, 13) eine Reihenschaltung aus einem Widerstand (19, 22) und einem Kondensator (20, 21) geschaltet ist.

6. Schaltungsanordnung nach einem der Ansprüche 1 bis 5, dadurch gekennzeichnet, daß jede Ansteuerlogik (2, 11) so ausgelegt ist, daß die Basis des zugeordneten Transistors über einen Widerstand (36) an eine Steuerspannungsquelle (31) mit positivem Potential (+E1, +E2) zum Durchschalten des Transistors und an eine Steuerspannungsquelle (41) mit negativem Potential (-E1, -E2) zum Sperren des Transistors geschaltet werden kann, wobei der Verbindungsstromkreis (9, 17) zwischen der Basis des Transistors und der Steuerspannungsquelle (31) mit positivem Potential (+E1, +E2) aus einer Reihenschaltung aus einem Stromregelkreis (30, 32, 33) zur Bereitstellung eines konstanten Stroms und einer Energiepeicher-Drossel (34) besteht, die bei Anliegen eines Durchschaltsignals zur Erhöhung der Anstiegsgeschwindigkeit des Transistor-Basisstroms sowie zur Kompensation der Eigenstörinduktivität des Emitters dient.

7. Schaltungsanordnung nach Anspruch 6, dadurch gekennzeichnet, daß im genannten Verbindungstromkreis (9, 17) eine Diode (35) parallel zu dem zwischen der Drossel (34) und der Basis des Transistors liegenden Widerstand (36) geschaltet ist, und der Anschlußpunkt zwischen Drossel und Widerstand über einen statischen Umschaltkontakt (38) mit der Steuerspannungsquelle (41) des negativen Potentials (-E2, -E3) verbunden ist.

8. Schaltungsanordnung nach Anspruch 6 oder 7, dadurch gekennzeichnet, daß der genannte Stromregelkreis (30, 32, 33) aus einem Meßwandler (33) zur Erfassung Stromes in der genannten Drossel (34), einem über den genannten Meßwandler (33) angesteuerten Regelverstärker (30) und einem über den Verstärker angesteuerten Umschaltkontakt (32) besteht, und so der Mittelwert des zerhackten Stroms konstant gehalten wird.

9. Schaltungsanordnung nach einem der Ansprüche 6 bis 8, dadurch gekennzeichnet, daß der Anschlußpunkt zwischen der Drossel (34) und dem Regelkreis (30, 32, 33) über eine Diode (40) mit der Steuerspannungsquelle (41) des negativem Potentials (-E1, -E2) verbunden ist, um den Rückfluß des Stroms zu ermöglichen.

FIG 1

FIG 2

FIG.5

FIG.6

FIG 3

FIG 4